# EUROPEAN PATENT APPLICATION

(11) **EP 2 894 640 A1**
(43) Date of publication of application: **15.07.2015**
(21) Application number: 14775617.5
(22) Date of filing: 14.01.2014
(51) Int. Cl.: H01B 1/08, H01B 13/00

(54) **TRANSPARENT COMPOUND SEMICONDUCTOR AND P-TYPE DOPING METHOD THEREFOR**

(30) Priority: 29.03.2013 KR 20130034563
(71) Applicant: RFtron Co., Ltd., Seoul 151-742 (KR)
(72) Inventor: CHAR, Kookrin, Gyeonggi-do 463-810 (KR); IHM, Jisoon, Seoul 137-841 (KR)
(74) Representative: TBK
(86) International application number: PCT/KR2014/000384
(87) International publication number: WO 2014/157818

(57) **Abstract**

The present invention relates to a p-type doped transparent compound semiconductor and a p-type doping method therefor, and the purpose thereof is to provide a transparent compound semiconductor having transparency and electrical conductivity by being p-type doped on the basis of either (Ba,Sr)SnO₃ or SnO₂. The present invention provides a p-type transparent compound semiconductor having either (Ba,Sr)SnO₃ or SnO₂ doped with M (M is one among Ru, Ga, Cu, Zn, K, Na or Rb), and a p-type doping method therefor. M substituted for (Ba,Sr) and Sn included in either (Ba,Sr)SnO₃ or SnO₂ has a composition of 0<x≤0.7. (Ba,Sr)SnO₃ refers to Ba_{1-y}Sr_{y}SnO₃ (0≤y≤1.0).

## Description

### [Technical Field]

The present invention relates to a transparent compound semiconductor and a method of manufacturing the same, and more particularly, to a P-type doped transparent compound semiconductor having transparency and electrical conductivity, and a method of P-type doping the same.

### [Background Art]

Currently, one of information and communication technology trends is fusing a function of an electronic device with a function of a display device. In order to fuse the functions of the electronic device and the display device, the electronic device should be transparent.

Therefore, studies on a transparent semiconductor in which functions of the electronic device are performed while satisfying transparency, a transparent conductor, and a method of manufacturing the same have been actively conducted. For example, indium tin oxide (ITO) has been developed and used as the transparent conductor and ZnO or the like has been developed. However, stability is reduced and thus the possibility of being applied to the transparent semiconductor is extremely limited.

### [Disclosure]

### [Technical Problem]

The present invention is directed to providing a P-type doped transparent compound semiconductor having transparency and electrical conductivity and a method of manufacturing the same.

### [Technical Solution]

One aspect of the present invention provides a P-type doped transparent compound semiconductor having one of (Ba,Sr)SnO₃ and SnO₂ doped with M (M is one among Ru, Ga, Cu, Zn, K, Na, and Rb), and (Ba,Sr)SnO₃ refers to Ba₁₋ySr_{y}SnO₃ (0≤y≤1.0).

The P-type doped transparent compound semiconductor has a composition of (Ba,Sr)Sn₁₋ₓMₓO₃ (0<x≤0.7), M is one among Ru, Ga, Cu, and Zn, and (Ba,Sr)Sn₁₋ₓMₓO₃ refers to Ba_{1-y}Sr_{y}Sn₁₋ₓMₓO₃ (0≤y≤1.0).

The P-type doped transparent compound semiconductor has a composition of (Ba,Sr)₁₋ₓMₓSnO₃ (0<x≤0.7), M is one among K, Na, and Rb, and (Ba,Sr)₁₋ₓMₓSnO₃ refers to (Ba_{1-y}Sr_{y})₁₋ₓMₓSnO₃ (0≤y≤1.0).

The P-type doped transparent compound semiconductor has a composition of Sn₁₋ₓMₓO₂ (0<x≤0.7) and M may be Ru.

Another aspect of the present invention provides a P-type doped transparent compound semiconductor having a composition of (Ba,Sr)Sn₁₋ₓRuₓO₃ (0<x≤0.7).

In the P-type doped transparent compound semiconductor, (Ba,Sr)Sn₁₋ₓRuₓO₃ may be formed by doping (Ba,Sr)SnO₃ with Ru.

Still another aspect of the present invention provides a P-type doped transparent compound semiconductor having a composition of (Ba,Sr)₁₋ₓKₓSnO₃ (0<x≤0.7).

In the P-type doped transparent compound semiconductor, (Ba,Sr)₁₋ₓKₓSnO₃ may be formed by doping (Ba,Sr)SnO₃ with K.

Yet another aspect of the present invention provides a method of manufacturing a P-type doped transparent compound semiconductor which is doped in the P-type by substituting one of (Ba,Sr) and Sn included in one of (Ba,Sr)SnO₃ and SnO₂ with M (M is one among Ru, Ga, Cu, Zn, K, Na, and Rb).

### [Advantageous Effects]

According to the transparent compound semiconductors according to the embodiments of the present invention, one of undoped (Ba,Sr)SnO₃ and SnO₂ is doped with M (M is one among Ru, Ga, Cu, Zn, K, Na, and Rb), and thus the P-type transparent compound semiconductor having transparency and electrical conductivity can be obtained.

### [Description of Drawings]

FIGS. 1 and 2 are high temperature current-voltage characteristic graphs showing samples manufactured using a transparent compound semiconductor according to a first exemplary embodiment of the present invention.
FIGS. 3 and 4 are room temperature current-voltage characteristic graphs showing the samples manufactured using the transparent compound semiconductor according to the first exemplary embodiment of the present invention.
FIGS. 5 and 6 are room temperature current-voltage characteristic graphs showing samples manufactured using a transparent compound semiconductor according to a second exemplary embodiment of the present invention.

### [Modes of the Invention]

The following descriptions will be made focusing on configurations necessary for understanding embodiments of the invention. Therefore, descriptions of other configurations that might obscure the gist of the invention will be omitted.

Terms and words, which are to be described below and used in this specification and claims, should not be interpreted as limited to commonly used meanings or meanings in dictionaries and should be interpreted with meanings and concepts which are consistent with the technological scope of the invention based on the principle that the inventors have appropriately defined concepts of terms in order to describe the invention in the best way. Therefore, since the embodiments described in this specification and configurations illustrated in drawings are only exemplary embodiments and do not represent the overall technological scope of the invention, it is understood that the invention covers various equivalents, modifications, and substitutions at the time of filing of this application.

Hereinafter, exemplary embodiments of the invention will be described in detail with reference to the accompanying drawings.

A transparent compound semiconductor according to an embodiment of the present invention is a P-type transparent compound semiconductor based on one of undoped (Ba,Sr)SnO₃ and SinO₂, and one of the undoped (Ba,Sr)SnO₃ and SnO₂ is doped with M (M is one among Ru, Ga, Cu, Zn, K, Na, and Rb). That is, in the transparent compound semiconductor according to the embodiment of the present invention, one of (Ba,Sr) and Sn included in one of the undoped (Ba,Sr)SnO₃ and SnO₂, is substituted with M and M has a composition of 0<x≤0.7. Here, (Ba,Sr) refers to Ba_{1-y}Sr_{y} (0≤y≤1.0). The SnO₂ is amorphous or crystalline.

For example, the transparent compound semiconductor according to the embodiment of the present invention may have a composition of (Ba,Sr)Sn₁₋ₓMₓO₃ (0<x≤0.7). In this case, M may be one among Ru, Ga, Cu, and Zn. (Ba,Sr)Sn₁₋ₓMₓO₃ refers to (Ba_{1-y}Sr_{y})Sn₁₋ₓMₓO₃.

The transparent compound semiconductor according to the embodiment of the present invention may have a composition of (Ba,Sr)₁₋ₓMₓSnO₃ (0<x≤0.7). Here, M may be one among K, Na, and Rb. (Ba,Sr)₁₋ₓMₓSnO₃ refers to (Ba_{1-y}Sr_{y})₁₋ₓMₓSnO₃.

The transparent compound semiconductor according to the embodiment of the present invention may have a composition of Sn₁₋ₓMₓO₂ (0<x≤0.7). In this case, M may be Ru. Here, since a P-type transparent compound semiconductor may be formed from (Ba,Sr)Sn₁₋ₓMₓO₃ and crystal structures of RuO₂ and SnO₂ are the same, the P-type transparent compound semiconductor according to the embodiment of the present invention is also formed from Sn₁₋ₓMₓO₂ (0<x≤0.7).

Here, M has a composition ratio of 0<x≤0.7 so that the transparent compound semiconductor according to the embodiment of the present invention has P-type semiconductivity. That is, for example, in the case in which x is zero, since (Ba,Sr)SnO₃ has the characteristics of an insulator, x should be greater than zero. For example, in the case in which the M is greater than 0.7 by doping, since (Ba,Sr)Sn₁₋ₓMₓO₃ is metallized, M should have the composition ratio of 0.7 or less. Therefore, M has the composition ratio of 0<x≤0.7 so that the transparent compound semiconductor according to the embodiment of the present invention has the P-type semiconductivity.

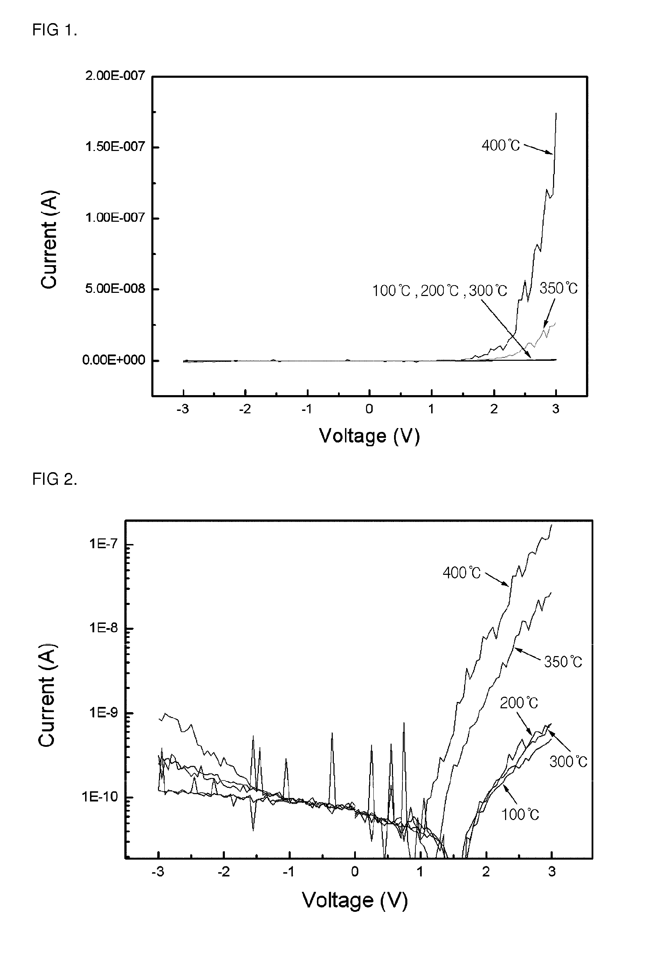

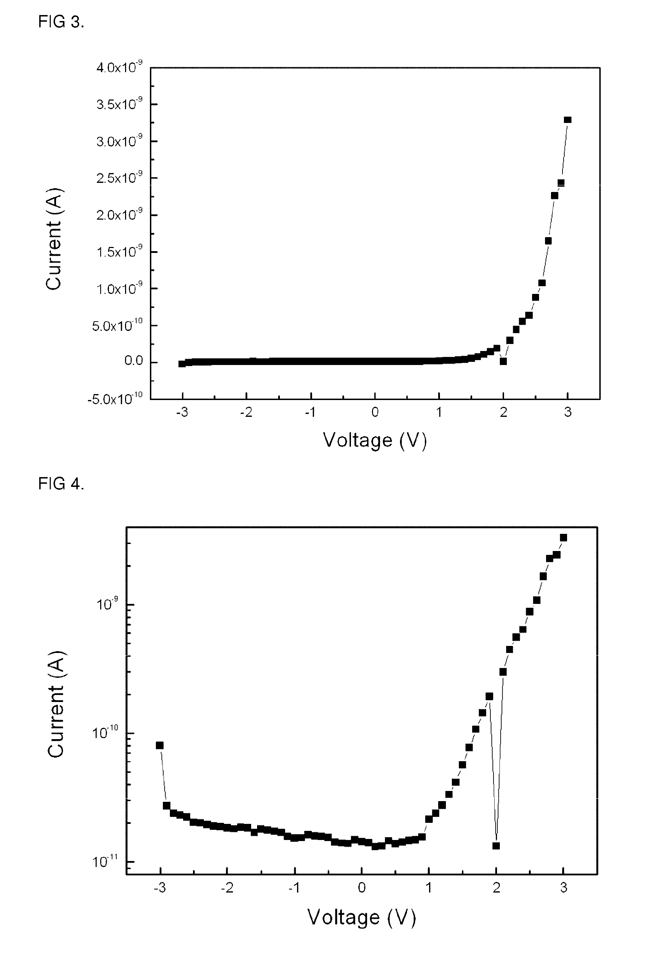

It may be found through a PN junction diode that the transparent compound semiconductor according to the embodiment of the present invention based on (Ba,Sr)SnO₃ has the P-type semiconductivity as shown in FIGS. 1 to 4. Here, FIGS. 1 and 2 are high temperature current-voltage characteristic graphs showing samples manufactured using a transparent compound semiconductor according to a first exemplary embodiment of the present invention. FIGS. 3 and 4 are room temperature current-voltage characteristic graphs showing the samples manufactured using the transparent compound semiconductor according to the first exemplary embodiment of the present invention. FIGS. 1 and 3 are linear scale current-voltage characteristic graphs and FIGS. 2 and 4 are log scale current-voltage characteristic graphs.

Ba₁₋ₓKₓSnO₃ (0<x≤0.7) is used as the transparent compound semiconductor according to the first exemplary embodiment of the present invention and Ba_{1-y}La_{y}SnO₃ (0<y<0.1) is used as an N-type transparent compound semiconductor.

The sample is formed by sequentially stacking Ba_{1-y}La_{y}SnO₃ (0<y<0.1) and Ba₁₋ₓKₓSnO₃ (0<x≤0.7) on a strontium tin oxide (STO) substrate. That is, an N-type first transparent compound semiconductor layer is formed by depositing Ba_{1-y}La_{y}SnO₃ on the STO substrate. Then, a second transparent compound semiconductor layer is formed by depositing Ba₁₋ₓKₓSnO₃ on the first transparent compound semiconductor layer. The second transparent compound semiconductor layer was formed using a stencil mask.

In the sample, the first and second transparent compound semiconductor layers were formed to have the same thickness.

In this case, Ba_{1-y}La_{y}SnO_{3,} which is the N-type transparent compound semiconductor and used for the sample, satisfies a composition ratio of (Ba+La):Sn=1:1.

Here, Ba_{1-y}La_{y}SnO₃ has the composition ratio of 0<x<0.1 so that Ba_{1-y}La_{y}SnO₃ has semiconductivity. In the case in which y=0, that is, La=0, since BaSnO₃ becomes an insulator, a composition ratio of La should be greater than zero. Further, in the case in which the composition ratio becomes 0.1 after doping with La, since Ba_{0.9}La_{0.1}SnO₃ becomes a metal, La should have the composition ratio smaller than 0.1. Therefore, Ba_{1-y}La_{y}SnO₃ has the composition ratio of 0<y<0.1 in order to have semiconductivity.

It is preferable that the Ba_{1-y}La_{y}SnO₃ is formed to have a thickness in a range of 0.4 nm to 400 nm so as to have good transparency, stability, and charge carrier mobility of 10 cm²/V sec or more. The reasons for forming Ba_{1-y}La_{y}SnO₃ to have the above thickness are as follows. First, since the thickness of 0.4 nm corresponds to a thickness of one atomic layer, Ba_{1-y}La_{y}SnO₃ may not be formed to have a thickness smaller than 0.4 nm. Also, transparency is reduced when the thickness of the Ba_{1-y}La_{y}SnO₃ is greater than 400 nm.

Ba_{1-y}La_{y}SnO₃ may be manufactured in a single crystal form or an epitaxial film form.

The N-type transparent compound semiconductor may be formed using Ba_{1-y}La_{y}SnO₃ as follows.

First, Ba_{1-y}La_{y}SnO₃ may be formed by doping the BaSnO₃ with La. BaSnO₃ is an insulating material, of which a lattice constant is 0.41 nm, has a band gap greater than 3 eV, and is transparent.

In this case, the reason that BaSnO₃ is used as a base material of the Ba_{1-y}La_{y}SnO₃ is as follows. First, in terms of the basic science, as an insulator of which the band gap is close to 4 eV is doped with a metal material at 10²⁰/cm³ or less, it is difficult to expect that a material, of which the charge carrier mobility is large, is present. However, in the embodiments of the present invention, it was found that it is possible to implement the high charge carrier mobility in a perovskite metal oxide structure having an ABO₃ structure such as the BaSnO₃ through A-site doping. That is, the perovskite metal oxide has a crystallization temperature higher than a metal oxide of the other structure, however, it has an advantage of providing a possibility in which a material is doped at two cation locations. Specifically, in the embodiments of the present invention, BaSnO₃ which is the perovskite metal oxide having the high band gap of 3 eV was used as the base material of the Ba_{1-y}La_{y}SnO₃.

BaSnO₃ has the band gap greater than 3 eV and it means that the transparency is high. Further, Ba_{1-y}La_{y}SnO₃ which uses BaSnO₃ having the high band gap has advantages in terms of the transparency compared to silicon having a band gap of about 1.2 eV or GaAs having a band gap of about 1.5 eV.

Alternatively, Ba_{1-y}La_{y}SnO₃ may be formed by reacting a Ba compound, a La compound, and a Sn compound. In this case, BaCO₃ or BaO may be used as the Ba compound. La₂O may be used as the La compound. And, SnO₂ may be used as the Sn compound. For example, the Ba compound, the La compound, and the Sn compound are mixed according to the composition ratio of Ba_{1-y}La_{y}SnO₃ (0<y<0.1), and then Ba_{1-y}La_{y}SnO₃ is manufactured by reacting the Ba compound, the La compound, and the Sn compound at a temperature in a range of 500 °C to 1500 °C. In this case, since a crystalline structure of Ba_{1-y}La_{y}SnO₃ is not formed at the temperature of 500 °C or less, and the crystalline structure of the Ba_{1-y}La_{y}SnO₃ is broken or a characteristic as the transparent compound semiconductor is degraded at the temperature greater than 1500 °C, the reaction is performed at a temperature in the range of 500 °C to 1500 °C.

When Ba_{1-y}La_{y}SnO₃ is formed by reacting the Ba compound, the La compound, and the Sn compound, a base substrate may be provided and the Ba_{1-y}La_{y}SnO₃ may be formed on the base substrate using a physical or chemical method. A material similar to BaSnO₃ of which the lattice constant is 0.41 nm as the perovskite metal oxide structure having the ABO₃ structure may be used as the base substrate. For example, SrTiO₃, LaAlO₃, SrZrO₃, BaNbO₃, or the like of which the lattice constant is in a range of 0.37 nm to 0.45 nm may be used as the base substrate, however it is not limited thereto.

Ba_{1-y}La_{y}SnO₃ formed by reacting the Ba compound, the La compound, and the Sn compound has the charge carrier mobility of 10 cm²/V sec or more. Specifically, Ba_{1-y}La_{y}SnO₃ has the charge carrier mobility of 10 cm²/V sec or more at a room temperature.

It was found whether the sample manufactured as described above has a characteristic of the PN junction diode or not through the current-voltage characteristic.

First, the current-voltage characteristic of the sample is checked at a high temperature, and thus it may be found that the sample shows a characteristic of a diode as shown in FIGS. 1 and 2.

Further, the current-voltage characteristic of the sample is checked at a room temperature, and thus it may be found that the sample shows the characteristic of the diode as shown in FIGS. 3 and 4.

Since the N-type first transparent compound semiconductor layer and the sample manufactured using Ba₁₋ₓKₓSnO₃ (0<x≤0.7) according to the embodiment of the present invention shows the characteristics of the diode, it may be found that Ba_{1-y}La_{y}SnO₃ (0<x≤0.7) according to the embodiment of the present invention has P-type semiconductivity.

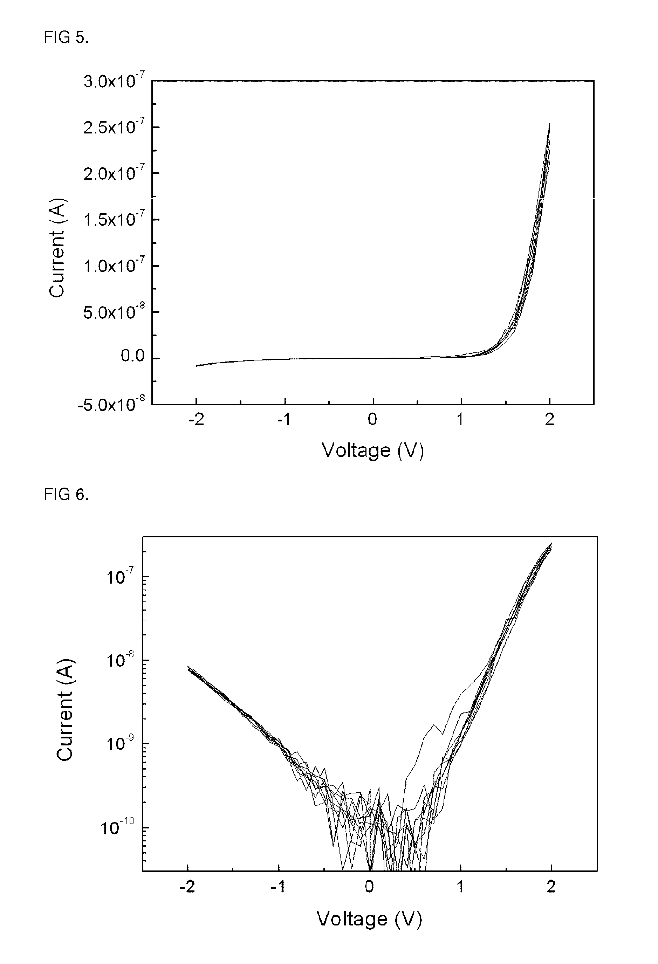

Then, it may be found through a PN junction diode that a transparent compound semiconductor according to the embodiment of the present invention based on SrSnO₃ has P-type semiconductivity as shown in FIGS. 5 and 6. Here, FIGS. 5 and 6 are current-voltage characteristic graphs showing samples manufactured using a transparent compound semiconductor according to a second exemplary embodiment of the present invention, at a room temperature. FIG. 5 is a linear scale current-voltage characteristic graph and FIG. 6 is a log scale current-voltage characteristic graph.

SrSn₁₋ₓRuₓO₃ (0<x≤0.7) was used for the transparent compound semiconductor according to the second exemplary embodiment of the present invention and SrSn_{1-y}Sb_{y}O₃ (0<y<0.1) was used for the N-type transparent compound semiconductor.

In this case, the sample is formed by stacking SrSn_{1-y}Sb_{y}O₃ (0<y<0.1) and SrSn₁₋ₓRuₓO₃ (0<x≤0.7) on a KTaO₃ (KTO) substrate. That is, an N-type first compound semiconductor layer is formed on the KTO substrate by depositing SrSn_{1-y}Sb_{y}O₃. Then, a second compound semiconductor layer is formed by depositing the SrSn₁₋ₓRuₓO₃ on the first compound semiconductor layer. In this case, SrRuO₃ is deposited on the second compound semiconductor layer. In this case, the second compound semiconductor layer and SrRuO₃ each were formed using a stencil mask.

It was found whether the sample manufactured as described above has a characteristic of the PN junction diode or not through the current-voltage characteristic.

First, the current-voltage characteristic of the sample is checked at a room temperature, and thus it may be found that the sample shows a characteristic of a diode as shown in FIGS. 5 and 6.

Since the N-type first transparent compound semiconductor layer and the sample manufactured using SrSn₁₋ₓRuₓO₃ (0<x≤0.7) according to the embodiment of the present invention show the diode characteristics, it may be found that SrSn₁₋ₓRuₓO₃ (0<x≤0.7) according to the embodiment of the present invention has P-type semiconductivity.

Further, the P-type semiconductivity of the transparent compound semiconductor having a composition of BaSn₁₋ₓMₓO₃ (0<x≤0.7) among the transparent compound semiconductors according to the embodiments of the present invention may also be found through the PN junction. For example, as described above, since the compound semiconductor, in which SrSnO₃ according to the second embodiment of the present invention is doped with Ru, shows the P-type semiconductivity, it may be indirectly found that the transparent compound semiconductor, in which BaSnO₃ is doped with Ru, also shows the P-type semiconductivity.

Further, the P-type semiconductivity of the transparent compound semiconductor having the composition of Sn₁₋ₓRuₓO2 (0<x≤0.7) among the transparent compound semiconductor according to the embodiment of the present invention may be found as follows. That is, since the P-type transparent compound semiconductors may be formed from BaSn₁₋ₓMₓO₃ and SrSn₁₋ₓMₓO₃, it may be indirectly found that Sn₁₋ₓMₓO₂ (0<x≤0.7) according to the embodiment of the present invention also shows the P-type semiconductivity.

The embodiments disclosed in this specification and drawings are only examples to help understanding of the invention and the invention is not limited thereto. It is apparent to those skilled in the art that various modifications based on the technological scope of the invention in addition to the embodiments disclosed herein can be made.

[Industrial Applicability]

## Claims

1. A P-type doped transparent compound semiconductor comprising one of (Ba,Sr)SnO₃ and SnO₂ doped with M (M is one among Ru, Ga, Cu, Zn, K, Na, and Rb),
wherein (Ba,Sr)SnO₃ refers to Ba_{1-y}Sr_{y}SnO₃(0≤y≤1.0).

2. The semiconductor of claim 1, further including a composition of (Ba,Sr)Sn₁₋ₓMₓO₃ (0<x≤0.7),
wherein M is one among Ru, Ga, Cu, and Zn, and (Ba,Sr)Sn₁₋ₓMₓO₃ refers to Ba_{1-y}Sr_{y}Sn₁₋ₓMₓO₃ (0≤y≤1.0).

3. The semiconductor of claim 1, further including a composition of (Ba,Sr)₁₋ₓMₓSnO₃ (0<x≤0.7),
wherein M is one among K, Na, and Rb, and (Ba,Sr)₁₋ₓMₓSnO₃ refers to (Ba_{1-y}Sr_{y})₁₋ₓMₓSnO₃ (0≤y≤1.0).

4. The semiconductor of claim 1, further including a composition of Sn₁₋ₓMₓO₂ (0<x≤0.7),
wherein M is Ru.

5. A P-type doped transparent compound semiconductor including a composition of (Ba,Sr)Sn₁₋ₓRuₓO₃ (0<x≤0.7),
wherein (Ba,Sr) refers to Ba_{1-y}Sr_{y} (0≤y≤1.0).

6. The semiconductor of claim 5, wherein (Ba,Sr)Sn₁₋ₓRuₓO₃ is formed by doping (Ba,Sr)SnO₃ with Ru.

7. A P-type doped transparent compound semiconductor including a composition of (Ba,Sr)₁₋ₓKₓSnO₃ (0<x≤0.7),
wherein (Ba,Sr) refers to Ba_{1-y}Sr_{y} (0≤y≤1.0).

8. The semiconductor of claim 7, wherein (Ba,Sr)₁₋ₓKₓSnO₃ is formed by doping (Ba,Sr)SnO₃ with K.

9. A method of manufacturing a P-type doped transparent compound semiconductor doped in the P-type by substituting one of (Ba,Sr) and Sn included in one of (Ba,Sr)SnO₃ and SnO₂ with M (M is one among Ru, Ga, Cu, Zn, K, Na, and Rb).
